(19) Europäisches Patentamt
European Patent Office
Office européen des brevets

(11) Veröffentlichungsnummer: **0 129 883**
**B1**

(12) # EUROPÄISCHE PATENTSCHRIFT

(45) Veröffentlichungstag der Patentschrift:
22.03.89

(51) Int. Cl.⁴: **H 05 K 7/14,** H 05 K 7/18

(21) Anmeldenummer: **84107202.8**

(22) Anmeldetag: **22.06.84**

(54) **Frontsystem für in Baugruppenträger einschiebbare Steckbaugruppen und rahmenartige Baugruppenträger zu deren Aufnahme.**

(30) Priorität: 24.06.83 DE 3322856
05.03.84 DE 3408073

(43) Veröffentlichungstag der Anmeldung:
02.01.85 Patentblatt 85/1

(45) Bekanntmachung des Hinweises auf die Patenterteilung:
22.03.89 Patentblatt 89/12

(84) Benannte Vertragsstaaten:
BE DE FR GB IT NL SE

(56) Entgegenhaltungen:
DE-A- 3 119 249
FR-A- 2 225 916
US-A- 4 243 283

(73) Patentinhaber: Siemens Aktiengesellschaft Berlin und München, Wittelsbacherplatz 2, D-8000 München 2 (DE)

(72) Erfinder: Bauer, Willi, PLanstrasse 20, D-7527 Kraichtal (DE)
Erfinder: Kessler, Otto, Am Rathausplatz 5, D-6729 Wörth (DE)
Erfinder: Klein, Klaus, Dipl.-Ing., Im Kirchbühl 3, D-7512 Rheinstetten 1 (DE)
Erfinder: Schmitt, Reinhard, Dipl.-Ing., August-Croissant Strasse 2, D-6740 Landau (DE)
Erfinder: Wojtas, Gerhard, Germersheimer Strasse 6, D-7500 Karlsruhe (DE)

## Beschreibung

Die Erfindung bezieht sich auf ein Frontsystem für in Baugruppenträger einschiebbare Steckbaugruppen und rahmenartige Baugruppenträger zu deren Aufnahme, mit an den Ecken der Frontkanten der Steckbaugruppen gelagerten Winkelhebeln, deren einer Hebelarm sich jeweils an dem Frontrahmen abstützt und deren anderer Hebelarm als Handhabe ausgebildet ist.

In bekannten Systemen werden die üblicherweise quaderförmigen Steckbaugruppen in die rahmenartigen, mit Führungen versehenen Baugruppenträger eingeschoben, bis die an ihrer rückwärtigen Kante angeordneten Steckelemente in Eingriff mit den entsprechenden Gegenelementen der Rückseitenverdrahtung kommen.

An derartige Systeme sind eine Reihe von Forderungen zu stellen:

Bei der Verwendung von Steckbaugruppen im 2- bis 3fachen Europaformat mit bis zu drei 96poligen Basissteckverbindungen steigen die erforderlichen Steck- und Ziehkräfte derart an, daß ein Hebelsystem zur Verminderung des Kraftaufwands beim Stecken und insbesondere beim Ziehen der Baugruppen vorzusehen ist.

Sich am Baugruppenträger abstützende, an den Baugruppen angebrachte Winkelhebel zum Lösen der Steckverbindungen sind bekannt, beispielsweise aus der US-A-4 243 283.

Anstelle der bisher üblichen Zeilenverriegelung von Baugruppen in Baugruppenträgern ist eine im Prinzip bekannte Einzelverriegelung vorzusehen.

Die Verbindung der Teile des Frontsystems mit den Baugruppen soll derart ausgebildet sein, daß eine universelle Anwendung bei verschiedenen Arten von Baugruppen möglich ist. Blindplatten zur Abdeckung nicht mit Baugruppen besetzter Abschnitte des Baugruppenträgers sind vorzusehen.

Auf eine großflächige und niederohmige Kontaktierung von mit Massepotential zu verbindenden Teilen, z. B. auch von Schirmen, mittels Frontstecker an die Baugruppen angeschlossener Kabel, wird besonderer Wert gelegt, um die Einstreuung von Störsignalen zu verhindern.

Aus dem gleichen Grunde ist gegebenenfalls auch eine Abschirmung der Frontseite der Baugruppen und der dort ankommenden Steckverbindungen vorzusehen.

Die Montage von Frontsteckern unterschiedlicher Polzahl und unabhängig vom Einbauort auf der Frontseite der Baugruppe soll möglich sein.

Es besteht demgemäß die Aufgabe, ein Frontsystem für Steckbaugruppen in Baugruppenträgern zu schaffen, mit dem sich die genannten Forderungen ohne besonderen Aufwand erfüllen lassen.

Die Aufgabe läßt sich erfindungsgemäß mit einem Frontsystem lösen, welches die Merkmale des Anspruchs 1 und wahlweise die der Unteransprüche aufweist. Ausführungsbeispiele sind in den Figuren 1 bis 16 dargestellt und im folgenden beschrieben.

Es zeigen
Fig. 1 die wesentlichen Teile des Frontsystems in perspektivischer Darstellung,
Fig. 2 ein Ausführungsbeispiel,
Fig. 3 eine Ausführungsform mit Frontleiste,
Fig. 4 eine Ausführungsform ohne Frontleiste,
Fig. 5 eine Ausführungsform mit Blindplatte,
Fig. 6 ein Ausführungsbeispiel eines Endstücks,
Fig. 7 ein Beispiel einer Endstückmontage,
Fig. 8 eine Ausführungsform der Frontleiste,
Fig. 9 eine Ausführungsform eines Formstücks zur Verbindung der Leiterplatte mit der Frontleiste,
Fig. 10 ein Montagebeispiel mit Frontstecker ohne Frontleiste,
Fig. 11 ein weiteres Ausführungsbeispiel,
Fig. 12 und Fig. 13 Einzelheiten mit einem vereinfachten Hebelsystem,
Fig. 14 und Fig. 15 Ausführungsformen von ohne Endstücke einsetzbaren Blindplatten,
Fig. 16 eine perspektivische Darstellung des Frontsystems mit Blindplatten gemäss Fig. 15.

Gleiche oder einander entsprechende Teile sind mit gleichen Bezugszeichen versehen.

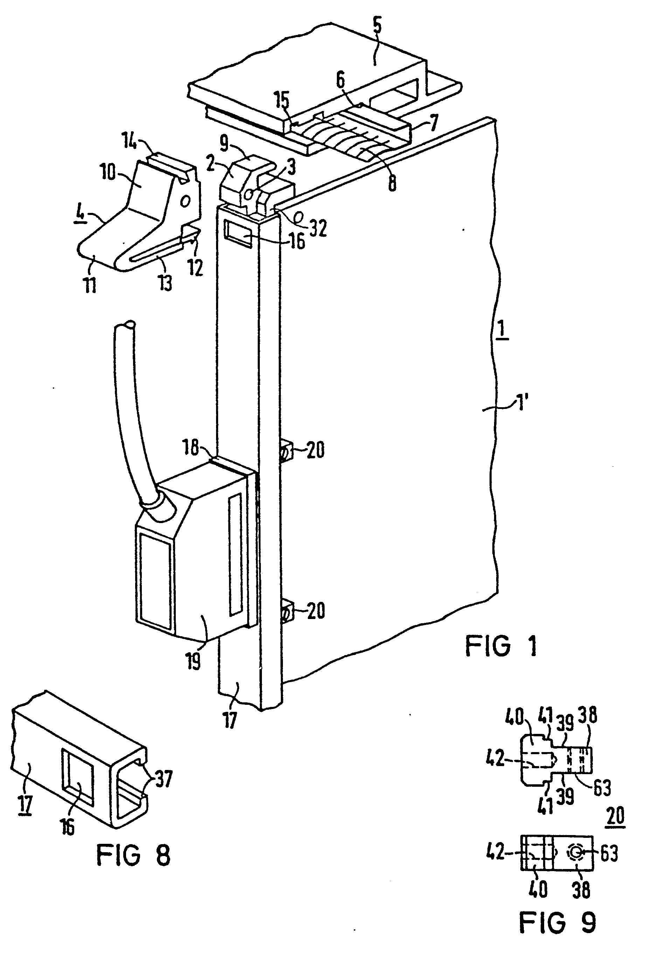

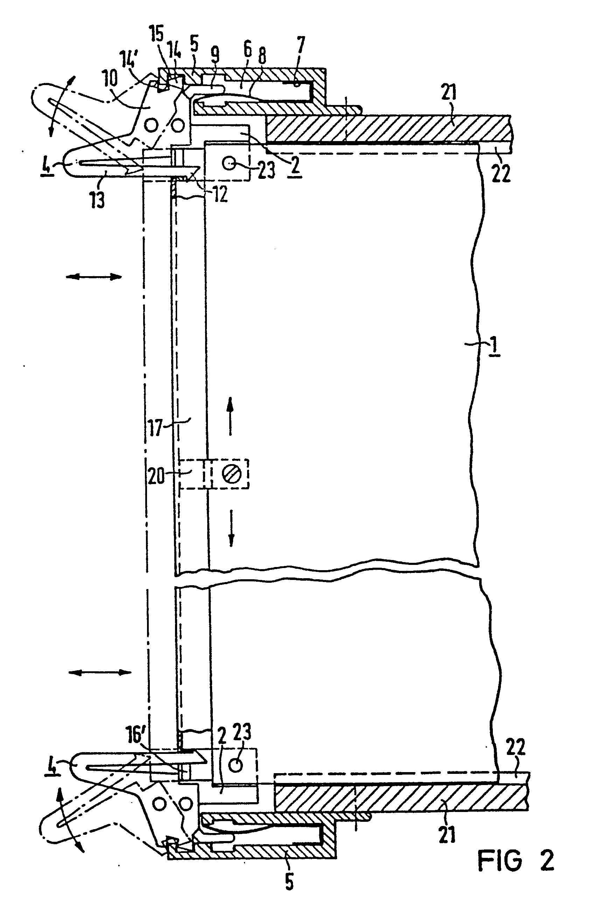

Fig. 1: Der vordere Teil einer Steckbaugruppe 1, die im wesentlichen aus einer bestückten Leiterplatte 1 besteht, ist an den Ecken von deren Frontkante mit je einem Endstück 2 aus elektrisch leitendem Material versehen, welches mit einem Masseleiter der Steckbaugruppe 1 verbunden und mit einer Aufnahme 3 für die Achse eines Winkelhebels 4 versehen ist. Das spiegelbildlich dazu angeordnete gleiche Endstück an der unteren Ecke ist der Einfachheit halber nicht eingezeichnet (siehe dazu Fig. 2).

Die an ihrer Rückseite mit Steckverbindern versehene Steckbaugruppe 1 wird in bekannter und deshalb nicht dargestellter Weise mit ihren Längskanten in Führungen eines rahmenartigen Baugruppenträgers eingeschoben, dessen Frontrahmen zwei parallele, senkrecht zur Einschubebene verlaufende Profilschienen 5 aufweist.

In dem Hohlraum 6, gebildet von dem nach vorn offenen, liegenden U-Profil der Profilschiene 5, ist als Kontaktmittel über dessen gesamte Länge eine Blattfeder 7 mit kammartig ausgebildeten Federzungen 8 angeordnet.

Jedes der Endstücke 2 mit einem aus zwei quaderförmigen Schenkeln gebildeten rechtwinkligen Grundprofil ist mit einer Kontaktfläche 9 versehen, die sich zungenförmig parallel zur Einschubrichtung erstreckt und in eingeschobenem Zustand der Steckbaugruppe 1 mit den Federzungen 8 der Blattfeder 7 in der Profilschiene 5 in großflächigen und demgemäß niederohmigen Kontakt kommt.

Der Winkelhebel 4, der mit seiner Drehachse senkrecht zur Einschubrichtung in dem Endstück 2 gelagert ist, weist an seinem als Handhabe ausgebildeten Hebelarm 11 eine sich von dessen freiem Ende in Richtung Drehachse erstreckende und auf deren Höhe mit einer Rastnase 12 versehene Blattfeder 13 auf.

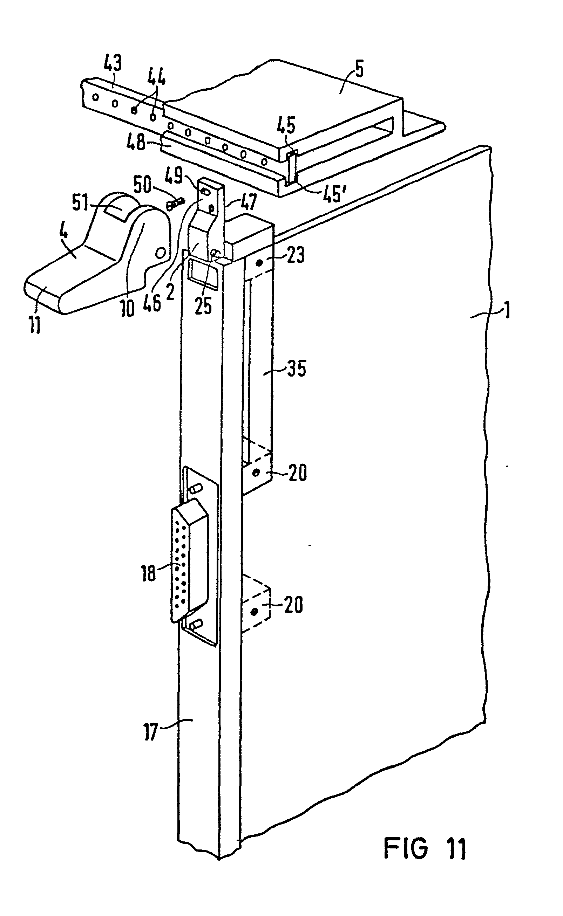

Der andere Hebelarm 10 stützt sich an der Stirnfläche der Profilschiene 5 ab, siehe auch Fig. 11.

In einer besonderen Ausführungsform ist das Ende des Hebelarms 10 mit einer Nase 14 versehen, die in eine auf der Innenseite des außen liegenden Schenkels der Profilschiene 5 angebrachte, parallel zur Stirnkante verlaufende Nut 15 eingreift.

Zur Verriegelung der Baugruppe 1 in dem Baugruppenträger greift die Rastnase 12 der Blattfeder 13 am Winkelhebel 4 in eine fensterartige Öffnung 16 ein, die jeweils am Ende einer Frontleiste 17 angebracht ist, welche aus elektrisch leitendem Material besteht und an der Frontkante der Baugruppe 1 befestigt ist.

Die Enden der Frontleiste 17 liegen an den in Richtung der Vorderkante verlaufenden Profilschenkeln 32 der Endstücke 2 an, so daß auch hier eine großflächige leitende Verbindung zu dem auf Massepotential liegenden Baugruppenträger entsteht und die Frontleiste 17 so als Abschirmung gegen elektromagnetische Einstreuungen wirkt.

Die Frontleiste 17 kann an beliebigen Stellen mit Durchbrechungen versehen werden, in welche die Steckfassung 18 eines Fronsteckers 19 oder andere Bedien- und Verbindungselemente eingefügt und in üblicher Weise an das Leiterbild der Steckbaugruppe 1 angeschlossen werden können.

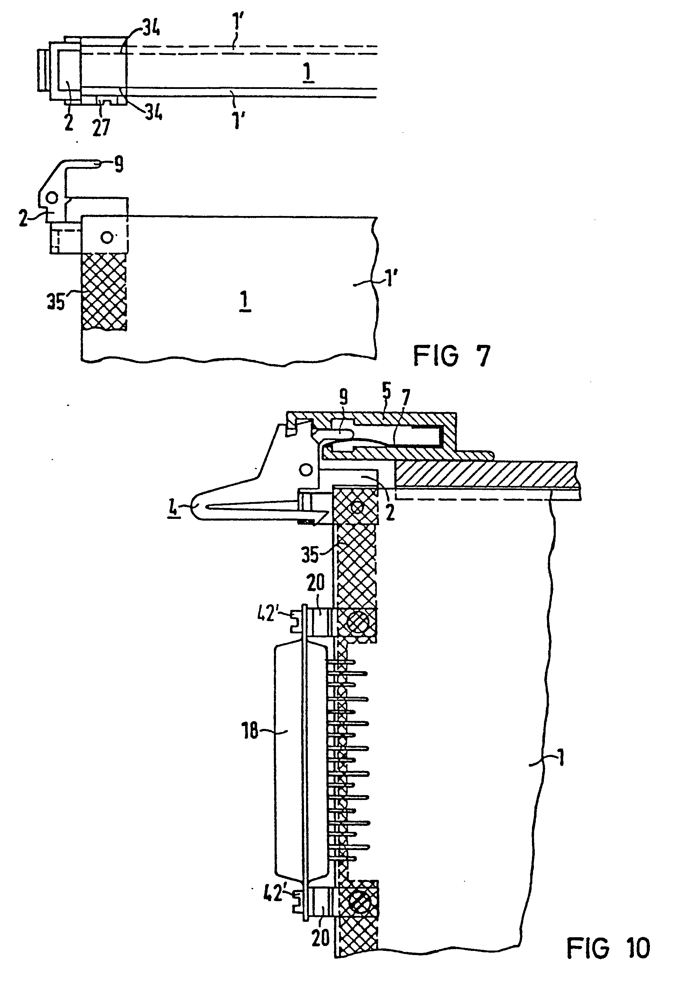

Um die Steckfassung 18 für den Frontstecker 19 an der Steckbaugruppe 1 zu befestigen und/oder um ein Durchbiegen der an sich nur an den Endstücken 2 befestigten Leiterplatte 1' der Steckbaugruppe 1, insbesondere bei mehrfachem Europaformat, zu verhindern, sind Formstücke 20 vorgesehen, die an der Vorderkante der Steckbaugruppe 1 und an der Frontleiste 17 befestigt sind, siehe auch Fig. 9.

Fig. 2 zeigt in einer Schnittzeichnung die Steckbaugruppe 1, die mit ihren Längskanten in Führungsnuten 22 von Rahmenelementen 21 des Baugruppenträgers eingeschoben ist.

Die Ecken der Frontkante der Steckbaugruppe 1 umgreifend sind mit dieser die Endstücke 2 mittels einer Schraub- oder Nietverbindung 23 derart verbunden, daß die Endstücke 2 mit den auf Massepotential zu legenden Leiterbahnen der Steckbaugruppe 1 in großflächigem Kontakt stehen.

Wie zu erkennen ist, steht die Kontaktfläche 9 der Endstücke 2 in elektrischer Verbindung mit den Federzungen 8 der auf Massepotential liegenden Blattfeder 7 in dem Hohlraum 6 der Profilschiene 5 des Baugruppenträgers.

Die Nase 14 des einen Hebelarms 10 des Winkelhebels 4 ist in die Nut 15 in der Innenseite des außen liegenden Schenkels der Profilschiene 5 eingetreten.

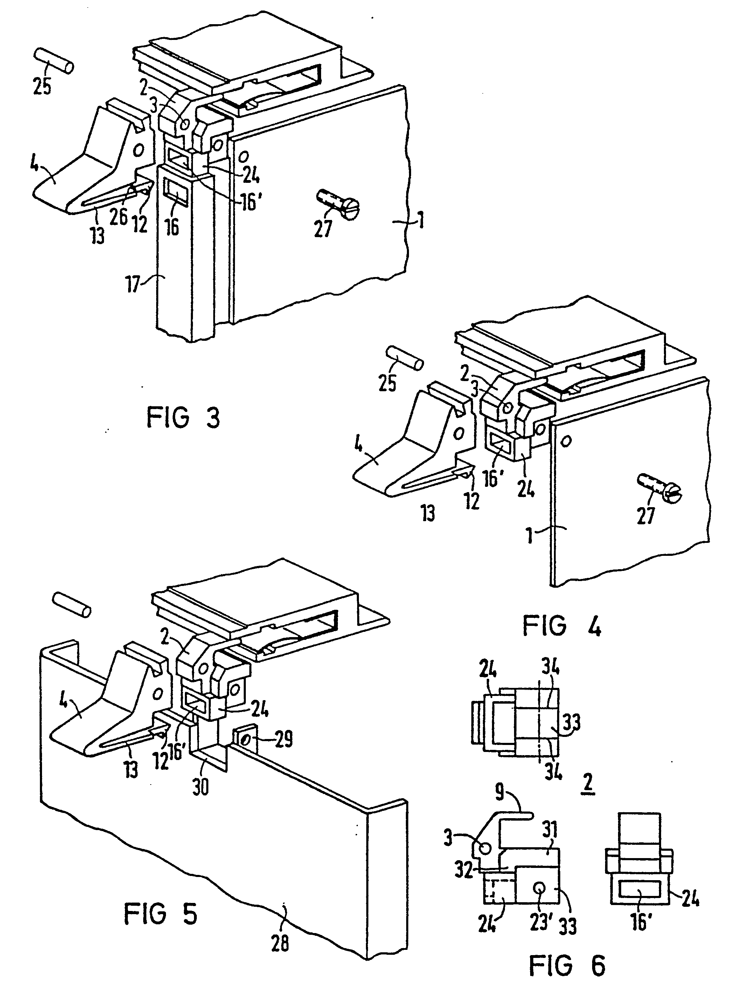

Die von dem als Handhabe ausgebildeten Hebelarm 11 des Winkelhebels 4 ausgehende Blattfeder 13 ist mit ihrer Rastnase 12 hinter der unteren Kante der Öffnung 16' (siehe auch Fig. 6) im Endstück 2 eingerastet, die Steckbaugruppe 1 ist also im Baugruppenträger verriegelt und der niederohmige Anschluss an Massepotential des Baugruppenträgers gewährleistet.

Um die Steckbaugruppe 1 aus ihrer – hier nicht gezeichneten – vielpoligen Steckverbindung mit der Rückseitenverdrahtung im Baugruppenträger zu lösen, werden beide mit ihren Drehachsen senkrecht zur Einschubebene in den Endstücken 2 gelagerte Winkelhebel durch Druck auf die Unterseite ihrer als Handhabe ausgebildeten Hebelarme 11 nach außen geschwenkt. Dabei werden die Blattfedern 13 der Rastvorrichtung nach innen gedrückt, so daß die Rastnase 12 aus ihrer Raststellung heraustreten kann, gleichzeitig stützt sich die Nase 14 am Hebelarm 10 des Winkelhebels 4 an der Innenkante der Nut 15 und eine weitere parallele Nase 14' an der Stirnfläche der Profilschiene 5 ab. Die Steckbaugruppe wird aus ihrer Steckverbindung gelöst und gelangt in die gestrichelt eingezeichnete Stellung, aus welcher sie leicht aus dem Baugruppenträger herauszuziehen ist.

Beim Einstecken der Steckbaugruppe 1 wird diese in die Führungsnuten 22 eingeführt, bis die Nasen 14 an den Enden 10 der Winkelhebel 4 in die Nuten 15 in den Profilschienen 5 eintreten.

Werden nun durch Druck auf die äußeren Flächen der als Handhabe ausgebildeten Hebelarme 11 der Winkelhebel 4 diese nach innen geschwenkt, so stützen sich wiederum die Nasen 14 an den Innenflächen der Nuten 15 ab und die Steckverbindung wird unter Überwindung der erheblichen Steckkräfte durch Ausnutzung der Hebelwirkung hergestellt.

Gleichzeitig rasten die Rastnasen 12 in der Endstellung wieder ein, so daß die Steckbaugruppe verriegelt ist.

Mit Hilfe der Winkelhebel 4 läßt sich so das Stecken und Ziehen der Steckbaugruppen, insbesondere solche mit mehreren vielpoligen Steckverbindern, erheblich erleichtern.

Zur mechanischen Versteifung kann die zwischen den einheitlich ausgebildeten Endstücken 2 angebrachte Frontleiste 17 beliebiger Länge an beliebigen Stellen mit der Frontkante der Steckbaugruppe 1 verbunden werden, und zwar mit Hilfe der bereits erwähnten Formstücke 20, deren eines Ende mit der Steckbaugruppe 1 verschraubt oder auf andere Weise verbunden ist und deren anderes Ende mit dem nach innen offenen Hohlprofil (siehe auch Fig. 8 und 9) der Frontleiste 17 längsverschieblich und formschlüssig gehalten ist.

Fig. 3 zeigt eine Ausführungsform, insbesondere die Verbindung von Frontleiste 17 mit dem Endstück 2, die der in Fig. 2 gezeigten entspricht.

Das Endstück 2 ist mit einem sich parallel zur Frontebene erstreckenden, rahmenförmigen Fortsatz 24 versehen, der an der Frontseite eine fensterartige Öffnung 16' aufweist, deren untere Kante als Rastkante für die Rastnase 12 des Winkelhebels 4 ausgebildet ist.

Der Fortsatz 24 ist so bemessen, daß sich das Ende der Frontleiste 17, die aus elektrisch leitendem U-Profilmaterial hergestellt ist, darüberschieben läßt, wobei die dort vorgesehene Öffnung 16 mit der Öffnung 16' im Frontsatz 24 in Deckung kommt.

Die Blattfeder 13 auf der Unterseite des mittels eines Achsstifts 25 in dem Endstück 2 drehbar gelagerten Winkelhebels 4 ist beidseitig mit schulterartigen Absätzen 26 versehen, die sich beim Einrasten an die der Öffnung 16 benachbarten Aussenfläche der Frontleiste 17 anlegen.

Falls die Forderung nach einer Abschirmung mit Hilfe der elektrisch leitenden Frontleiste 17 nicht im Vordergrund steht oder auf andere Weise gelöst ist, kann, wie Fig. 4 zeigt, die Frontleiste 17 weggelassen werden, wodurch die Funktion des Winkelhebels 4 beim Ziehen, Stecken und Verriegeln nicht beeinträchtigt wird.

Die Steckbaugruppe 1 wird an ihren vorderen Ecken mit Hilfe von Schrauben 27 mit Anlageflächen der Endstücke 2 verbunden.

Zur Verriegelung rastet die Rastnase 12 der Blattfeder 13 am Winkelhebel 4 in die Öffnung 16' im Fortsatz 24 des Endstücks 2 ein.

Sind Baugruppen mit größerer Frontfläche oder ein freigelassener Raum im Baugruppenträger frontseitig zu überdecken, so kann dies mit Hilfe von einer oder mehreren Blindplatten 28 geschehen, wie Fig. 5 zeigt. Das aus Endstück 2 und Winkelhebel 4 bestehende Verriegelungssystem kann auch hier eingesetzt werden, indem die Blindplatte 28 mit Hilfe einer rückseitig angebrachten Lasche 29 mit dem Endstück 2 verbunden wird.

In der Mitte der Ober- bzw. Unterkante der Blindplatte 28 ist je eine Ausnehmung 30 angebracht, in welcher der rahmenartige Fortsatz 24 des Endstücks 2 eintritt, so dass die Rastnase 12 der Blattfeder 13 in die Öffnung 16' eintreten und dort in der bereits beschriebenen Weise einrasten kann. Eine weitere Möglichkeit besteht darin, Endstücke 2 ohne den Fortsatz 24 zu verwenden und die Oberkante der Blindplatte 28 so auszubilden, dass die Rastnase 12 hinter ihr einrasten kann.

In Fig. 6 ist eine bevorzugte Ausführungsform eines Endstücks 2 in drei Ansichten dargestellt.

Es besteht im wesentlichen aus einem Winkelprofil mit einem langen Schenkel 31 und einem kürzeren Schenkel 32, der nach unten in den rahmenartigen Fortsatz 24 mit der Öffnung 16' übergeht. Zwischen den Profilschenkeln 31 und 32 erstreckt sich ein plattenförmiger Fortsatz 33, der mittig eine parallel zur Achsbohrung 3 für den Achsstift 25 (Fig. 3) des Winkelhebels 4 verlaufende Durchgangsbohrung 23' für eine Schraub- oder Nietverbindung 23 (Fig. 2) und zwei zur Einschubebene parallele Anlageflächen 34 aufweist.

Parallel zum Profilschenkel 31 erstreckt sich die zungenförmige Kontaktfläche 9, deren Zweck in der Beschreibung zu den Fig. 1 und 2 erläutert ist.

Um elektromagnetische Einstreuungen zu verhindern, sind entlang der Ränder von bestückten Leiterplatten 1' von Steckbaugruppen 1 breite Leiterbahnen 35 vorgesehen, die auf Massepotential zu legen sind.

Wie in Fig. 7 dargestellt, können eine oder zwei zu der Steckbaugruppe 1 gehörende Leiterplatten 1' mit den Anlageflächen 34 eines Endstücks 2 mittels der Schrauben 27 großflächig verbunden und die Leiterbahnen 35 so niederohmig kontaktiert werden.

Fig. 8 zeigt eine bevorzugte Ausführungsform der Frontleiste 17 als U-förmiges Hohlprofil mit eingezogenen Rändern 37. Die Frontleiste 17 kann konstruktiv sehr leicht ausgeführt werden, da sie keinerlei Tragfunktion für Steck- oder Bedienungsteile auszuüben hat und lediglich zum Schutz vor mechanischen oder elektrischen Störeinwirkungen dient.

Das in Fig. 9 in zwei Ansichten dargestellte Formstück 20, das, wie in Fig. 1 und 2 bereits dargestellt, zur Verbindung der Steckbaugruppe 1 bzw. von deren Leiterplatten 1' mit der Frontleiste 17 und/oder der Steckfassung 18 eines Frontsteckers 19 dient, weist einen quaderförmigen Teil 38 auf, der, wie auch beim Endstück 2 (Fig. 6), mit Anlageflächen 39 und einer Bohrung 63 zur Niet- oder Schraubverbindung mit der Frontkante der Steckbaugruppe bzw. mit deren Leiterplatte(n).

Der andere, hammerartig verbreiterte Teil 40 des Formstücks 20 ist so bemessen, daß er gleitend in den Hohlraum der Frontleiste 17 nach Fig. 8 einführbar und dort längsverschieblich gehalten wird, wobei die eingezogenen Ränder 37 der Frontleiste 17 hinter entsprechende Kanten 41 an der Rückseite des Teils 40 des Formstücks 20 greifen.

Das Formstück 20 kann von seiner Stirnseite her mit einem Gewindeloch 42 für Befestigungsschrauben von frontseitig anzuordnenden Bedienungs- oder Verbindungselementen, insbesondere von Steckfassungen für Frontstecker, versehen werden.

In Fig. 10 ist die Anbringung einer derartigen Steckfassung 18 für Frontstecker an der Frontkante der Steckbaugruppe 1 dargestellt.

Die aus leitendem Material bzw. mit leitender Oberfläche hergestellten Formstücke 20 sind mit der Frontkante der Steckbaugruppe 1 verschraubt und kontaktieren die dort verlaufende Leiterbahn 35 für Massepotential.

Mittels der Befestigungsschrauben 42' ist die Steckfassung 18 bzw. deren metallisches Gehäuse mit den Formstücken 20 verbunden.

Beim Einstecken eines Frontsteckers wird dessen Abschirmung über die Steckfassung 18, Formstücke 20, Leiterbahn 35, Endstücke 2, deren Kontaktfläche 9 und die Blattfeder 7 an die auf Massepotential liegende Profilschiene 5 des Baugruppenträgers angeschlossen.

Wie zu erkennen ist, kann diese Anordnung mit oder ohne Frontleiste 17 verwendet werden.

Anstelle der Blattfeder 7 tritt in der in Fig. 11 dargestellten Ausführungsform als Kontaktmittel eine Kontaktschiene 43 aus elektrisch leitendem Material, vorzugsweise aus Kupfer, die mit einer Reihe von Gewindebohrungen 44 versehen ist.

Die Kontaktschiene 43 ist in zwei gegenüberliegenden Nuten 45, 45' in den Innenflächen der Schenkel des U-Profils der Profilschiene 5 eingeschoben.

Das Endstück 2 weist anstelle der zungenförmigen Kontaktfläche 9 (Fig. 9) einen Fortsatz 46 auf, der mit einem Durchgangsloch 49 versehen ist und dessen frontparallele Flächen 47 bei eingeschobener Steckbaugruppe 1 an der Frontfläche 48 der Profilschiene 5 anliegt. Eine durch das Durchgangsloch 49 geführte Schraube 50 wird in eine Gewindebohrung 44 der Schiene 43 eingeschraubt, verbindet so elektrisch und mechanisch das Endstück 2 mit der auf Massepotential liegenden Kontaktschiene 43 und wirkt damit als Kontakt- und Verriegelungsmittel.

Der auf dem Achsstift 25 als Drehachse gelagerte Winkelhebel 4 weist hier einen als Handhabe ausgebildeten Hebelarm 11 ohne Rasteinrichtung auf, sein anderer Hebelarm 10 ist mit einem breiten Schlitz 51 versehen, um die Schraube 50 betätigen zu können.

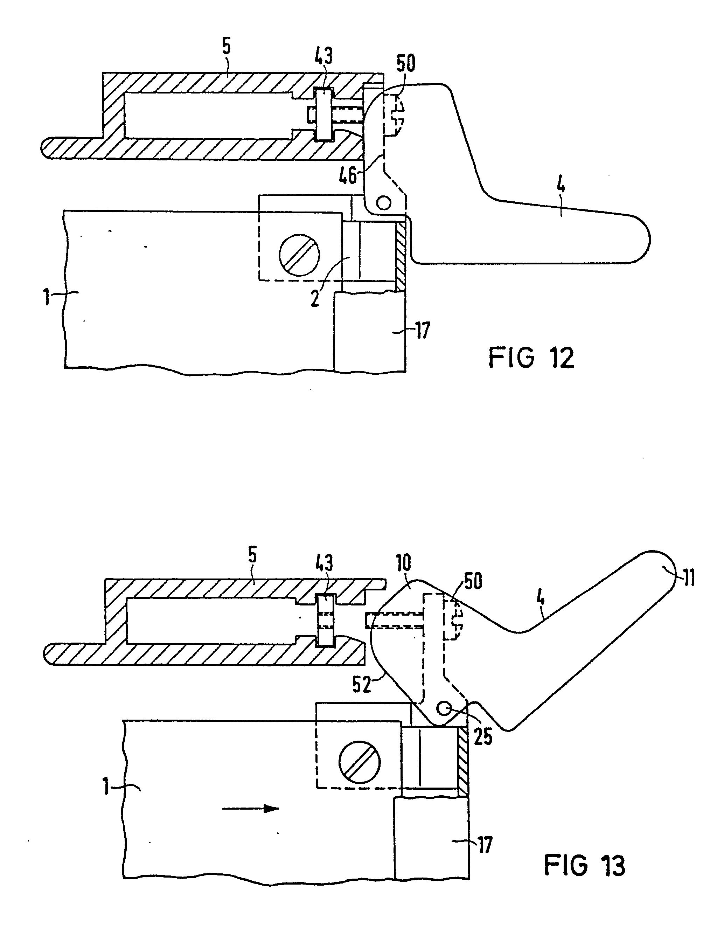

In Fig. 12 ist ein Ausschnitt des Systems nach Fig. 11 in Arbeitsstellung dargestellt.

Die Baugruppe 1 ist in den Baugruppenträger eingeschoben, in dessen frontseitiger Profilschiene 5 die Kontaktschiene 43 als Massekontakt angeordnet ist.

Der Fortsatz 46 des mit der Baugruppe 1 verschraubten Endstücks 2 liegt an der Frontfläche der Profilschiene 5 an und ist mittels der Schraube 50 mit der Kontaktschiene 43 verbunden.

Der Winkelhebel 4 befindet sich in der gezeichneten Stellung.

Zum Herausnehmen der Baugruppe 1 wird, wie Fig. 13 zeigt, die Schraube 50 aus der Kontaktschiene 43 herausgeschraubt und dann der Winkelhebel 4 durch Druck auf seinen Hebelarm 11 um die Achse 25 im Endstück 2 nach außen geschwenkt. Dabei stützt sich die in Form einer Abrollkurve gebogene Fläche 52 des Hebelarms 10 an der Frontfläche der Profilschiene 5 gleitend ab, bis die Steckverbindung an der Rückseite der Baugruppe 1 gelöst ist.

Falls erforderlich, kann der Hebelarm 10 des Winkelhebels 4 auch entsprechend der in Fig. 1 dargestellten Form ausgebildet, d.h. mit einer Nase 14 versehen sein, die in eine vor den Längsnuten 45, 45' angeordnete Nut 15 eingreift, wie es in der Beschreibung zu der Fig. 2 erläutert ist.

Werden in Frontsystemen in größerem Umfang Blindplatten verschiedener Größe benötigt, so erweisen sich Blindplatten, wie sie in Fig. 5 dargestellt sind, als relativ aufwendig, da sie aus mehreren Teilen zusammengefügt werden müssen.

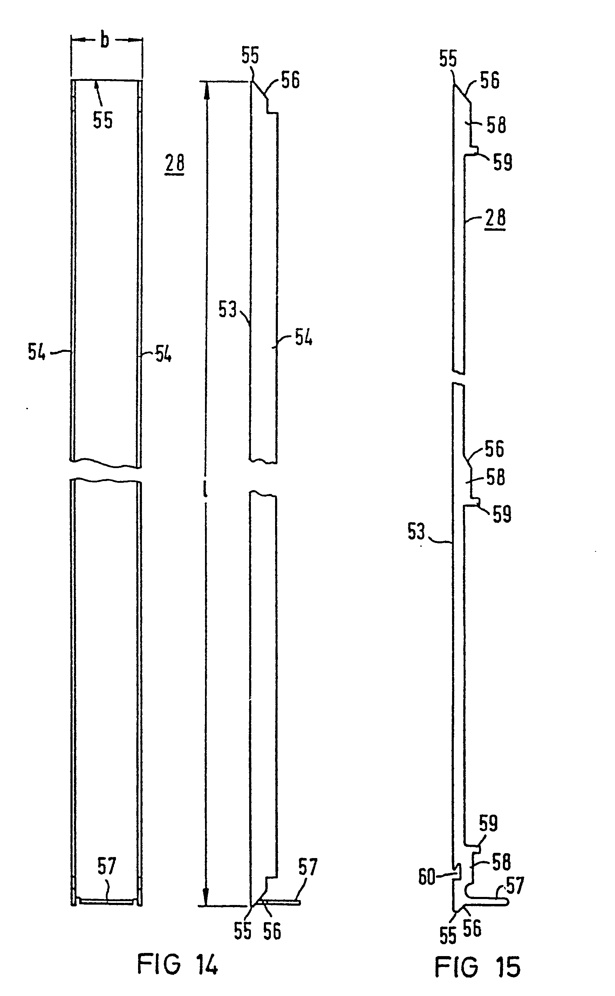

Fig. 14 zeigt in zwei Ansichten eine Blindplatte, die ohne Endstücke und Winkelhebel in die Frontseite des Baugruppenträgers eingefügt und mit Masse verbunden werden kann. Die Blindplatte 28 ist in dieser Ausführungsform aus einem U-Profil oder als Blechbiegeteil hergestellt und weist eine rechteckige Frontfläche 53 und senkrecht hochgezogene Längsseiten 54 auf, so daß ein U-förmiger Querschnitt entsteht.

An beiden Enden der Blindplatte 28 sind die hochgezogenen Längsseiten 54 in Richtung auf die Kante der Schmalseiten 55 mit einer Abschrägung 56 versehen.

An einem Ende, hier dem unteren Ende, der Blindplatte 28 ist ein Fortsatz 57 rechtwinklig nach rückwärts abgebogen, und zwar so, daß seine Mittelebene etwa einen oder zwei Millimeter von der benachbarten Schmalseite 55 entfernt ist.

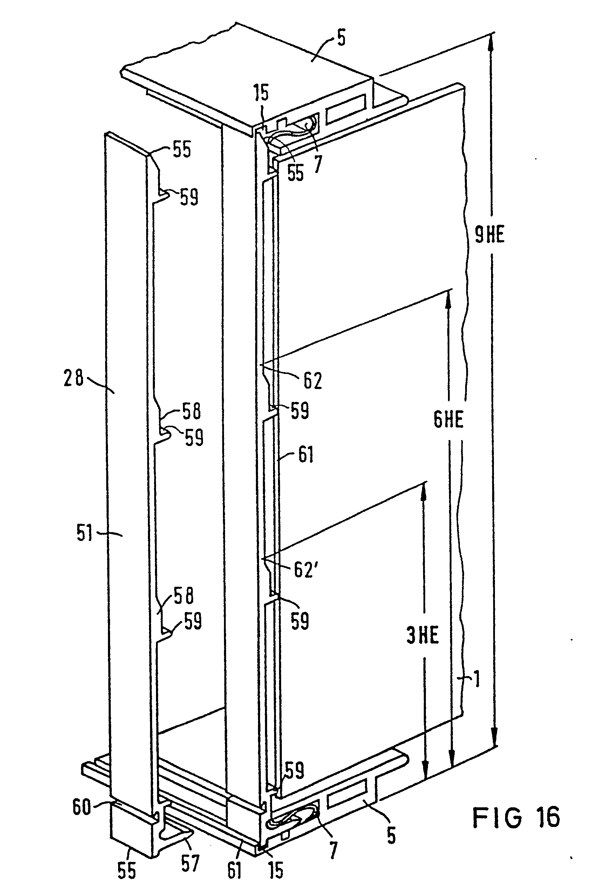

Die Funktion des Fortsatzes 57 wird in der Beschreibung zu Fig. 16 näher erläutert.

Die Breite b der Blindplatte 28 kann beliebig gewählt werden, vorzugsweise als Vielfaches einer Grundbreite, bezogen auf die Frontabmessungen des Baugruppenträgers, in welchem sie verwendet werden soll.

Die Länge 1 der Blindplatte 28 hängt im wesentlichen von dem Abstand der Profilschienen im Baugruppenträger ab, wie ebenfalls in Fig. 16 näher erläutert wird.

Statt als Blechbiegeteil kann eine Blindplatte dieser Art auch aus dünnwandigem U-Profilmaterial hergestellt werden, die Enden der Profilabschnitte werden entsprechend abgeschrägt, es werden Ausklinkungen entlang den Innenkanten des Profils vorgenommen und die so entstandene Zunge als Fortsatz 57 nach rückwärts abgebogen.

In Fig. 15 ist eine andere, bevorzugte Ausführungsform einer Blindplatte 28 im Querschnitt dargestellt, welche aus einem Leichtmetall-Strangpreßprofil durch Abtrennen quer zur Preßrichtung herstellbar ist.

Gleiche Teile tragen die gleichen Bezugszeichen wie bei der Ausführung nach Fig. 14.

Das Strangpreßprofil weist eine oder mehrere die Biegesteifigkeit erhöhende Rippen 58 auf, deren eine Längsseite jeweils als rampenartige Abschrägung 56 ausgebildet ist, die, wie am oberen und unteren Ende der Blindplatte 28 zu sehen ist, gegen deren Schmalseiten 55 verläuft.

An einem, hier dem unteren Ende der Blindplatte 28 weist das Profil eine hohe schmale Rippe als Fortsatz 57 auf, der senkrecht zur Plattenebene nach rückwärts gerichtet ist. Unterhalb des Fortsatzes 57 verläuft das Profil mit einer Abschrägung 56 wieder in die Schmalseite 55.

Die der Breite des Strangpreßprofils entsprechende Länge 1 der Blindplatte 28 entspricht den Höhenabmessungen der verwendeten Baugruppenträger.

Die Rippen 58 können mit senkrecht zur Plattenebene verlaufenden Fortsätzen 59 versehen sein, deren Zweck in der Beschreibung zu Fig. 16 erläutert wird.

In der Frontfläche 53 der Blindplatte 28 ist eine querverlaufende nutartige Griffmulde 60 vorgesehen, die zur leichteren Handhabung bei der Montage der Blindplatte dient.

Fig. 16 zeigt den Einsatz der Blindplatten 28, hier in der Bauart nach Fig. 15, in dem Frontsystem.

Die Profilschienen 5 in der Frontseite des Baugruppenträgers, mit einem liegenden, nach vorne offenen U-Profil, sind in der in den Fig. 1 und 2 dargestellten Weise gestaltet. Man erkennt die auf Massepotential liegenden Blattfedern 7 in den Hohlräumen des U-Profils und die Nuten 15.

Zum Einsetzen einer Blindplatte 28 in die Frontseite des Baugruppenträgers wird diese mit ihrer oberen Schmalseite 55 unter leichter Schrägstellung in die Nut 15 eingeführt, dann in Richtung auf die untere Profilschiene 5 eingeschwenkt, wobei der Fortsatz 57 am unteren Ende in den Hohlraum der Profilschiene 5 eintritt, dort von der Blattfeder 7 kraftschlüssig gehalten und mit Massepotential verbunden wird.

Die untere Schmalseite 55 der Blindplatte 28 schnappt dabei über die Kante 61 der Profilschiene 5 in die untere Nut 15 ein.

Beim Herausnehmen einer Blindplatte 28 verläuft der Vorgang umgekehrt, indem sie mit Hilfe eines in die Griffmulde 60 eingeführten einfachen Hilfsmittels, beispielsweise einer Schraubendreherklinge, leicht angehoben und dann aus der unteren Nut 15 über die Kante 61 herausgeschwenkt wird.

Die Länge der Blindplatte 28 ist deshalb so zu bemessen, daß sie etwa um die Tiefe der Nut 15 größer ist als der Abstand zwischen den einander zugekehrten Schenkelflächen der Profilschienen 5.

Dies gilt auch für die Länge 1 der hier nicht dargestellten Blindplatte in der Ausführung nach Fig. 14.

Für in Baugruppenträger einschiebbare Steckbaugruppen gibt es ein einheitliches Grundformat, das sogenannte Europaformat. Es ist jedoch auch möglich, Baugruppen in 2- oder 3fachem Europaformat auszuführen, entsprechend sind dann die Baugruppenträger ausgebildet.

Der in Fig. 16 dargestellte Baugruppenträger ist für Baugruppen in 3fachem Europaformat eingerichtet, seine Höhe entspricht neun Höheneinheiten HE, wobei eine Höheneinheit = 44,45 mm ist.

Um die Blindplatte 28 in der Ausführung nach Fig. 15 auch in Baugruppenträgern für doppeltes Europaformat mit sechs Höheneinheiten oder für einfaches Europaformat mit drei Höheneinheiten verwenden zu können, sind die Rippen 58 in solchen Abständen angeordnet, daß beim Durchtrennen der Blindplatte bzw. des Strangpreßprofils, aus welchem sie hergestellt ist, an den Trennstellen 62 oder 62' Blindplatten mit den benötigten Höhenabmessungen 6 HE oder 3 HE herstellbar sind. Es erübrigt sich so die Fertigung unterschiedlicher Strangpreßprofile bzw. die Vorratshaltung von Platten unterschiedlicher Länge.

Wie bereits erwähnt, dienen die Blindplatten zur Abdeckung von nicht mit Baugruppen besetzten Abschnitten des Baugruppenträgers bzw. von solchen Abschnitten, die mit Baugruppen ohne Frontplatte bestückt sind.

Der vordere Teil einer derartigen Baugruppe 1 ist in der Fig. 16 dargestellt.

Um eine Lockerung der Steckverbindung derartiger Steckbaugruppen bei starken Erschütterungen zu verhindern, sind die Fortsätze 59 der Rippen 58 so ausgebildet, daß sie an der Vorderkante 61 der Baugruppe 1 anliegen und diese arretieren.

**Patentansprüche**

1. Frontsystem für in Baugruppenträger einschiebbare Steckbaugruppen und rahmenartige Baugruppenträger zu deren Aufnahme, mit an den Ecken der Frontkanten der Steckbaugruppen gelagerten Winkelhebeln, deren einer Hebelarm sich jeweils an dem Frontrahmen abstützt und deren anderer Hebelarm als Handhabe ausgebildet ist, gekennzeichnet durch

a) zwei parallele, senkrecht zur Einschubebene verlaufende Profilschienen (5) mit nach vorn offenem U-Profil als Teile des Frontrahmens des Baugruppenträgers, die über ihre gesamte Länge mit in dem Hohlraum des Profils angeordneten, mit Masse verbundenen Kontaktmitteln (7, 43) ausgestattet sind;

b) an den Ecken der Frontkante jeder Steckbaugruppe (1) befestigte und mit einem Masseleiter der Steckbaugruppe verbundene Endstücke (2), die mit einem mit den Kontaktmitteln (7, 43) leitend verbindbaren Teil (9, 46) versehen und an denen die Winkelhebel (4) mit ihren Drehachsen senkrecht zur Einschubebene gelagert sind;

c) eine Frontleiste (17) aus elektrisch leitendem Profilmaterial mit Mitteln zu ihrer Verbindung mit der Frontkante der Steckbaugruppe (1) und/oder mit den Endstücken (2).

2. Frontsystem nach Anspruch 1, gekennzeichnet durch

– eine in der Innenseite des außen liegenden Schenkels der Profilschiene (5) parallel zu seiner Vorderkante verlaufende Nut (15),

– eine am Ende des abstützenden Hebelarms (10) des Winkelhebels (4) angebrachte, in die Nut (15) eingreifende Nase (14).

3. Frontsystem nach Anspruch 1, gekennzeichnet durch

– eine an dem als Handhabe ausgebildeten Hebelarm (11) des Winkelhebels (4) angebrachte und in eine Öffnung (16) in der Frontleiste (17) und/oder in eine Öffnung (16') in dem Endstück (2) eingreifende Rastvorrichtung (12, 13).

4. Frontsystem nach Anspruch 3, dadurch gekennzeichnet, daß die Rastvorrichtung aus einer sich vom freien Ende des Hebelarms (11) in Richtung Drehachse des Winkelhebels (4) erstreckenden und an ihrem Ende mit einer Rastnase (12) versehenen Blattfeder (13) besteht.

5. Frontsystem nach Anspruch 1 und 4, dadurch gekennzeichnet, daß die Frontleiste (17) und/oder ein sich unterhalb der Winkelhebelachse erstreckender Fortsatz (24) des Endstücks (2) mit jeweils einer Öffnung (16, 16') versehen ist, hinter eine von deren zur Drehachse des Winkelhebels (4) parallele Kanten die Rastnase (12) greift.

6. Frontsystem nach Anspruch 1, dadurch gekennzeichnet, daß das Kontaktmittel in dem Hohlraum (6) der Profilschiene (5) eine Blattfeder (7) mit kammartig ausgebildeten Federzungen (8) ist und daß jedes Endstück (2) mit einer zungenförmigen Kontaktfläche (9) versehen ist, die sich parallel zur Einschubrichtung erstreckt und bei eingeschobener Steckbaugruppe (1) in Kontakt mit der Blattfeder (7) steht.

7. Frontsystem nach Anspruch 1, dadurch gekennzeichnet, daß das Kontaktmittel mindestens eine mit einer Reihe von Gewindebohrungen (44) versehene Kontaktschiene (43) ist, die in zwei einander gegenüberliegenden Nuten (45, 45') in den Innenseiten der Schenkel des U-Profils der Profilschiene (5) eingeschoben sind und daß die Endstücke (2) mittels Schraubverbindungen (50) an den Kontaktschienen (43) befestigbar sind.

8. Frontsystem nach Anspruch 1, dadurch gekennzeichnet, daß als Mittel zur Verbindung der Frontleiste (17) mit der Baugruppe (1) Formstücke (20) vorgesehen sind, die einerseits mit einem quaderförmigen Teil (38) an der Frontkante der Baugruppe (1) zu befestigen und andererseits derart ausgebildet sind, daß sie in einem zur Baugruppe hin offenen Hohlprofil der Frontleiste (17) längsverschiebbar und formschlüssig gehalten sind.

9. Frontsystem nach Anspruch 1 und 8, dadurch gekennzeichnet, daß elektrisch leitende Formstücke (20) an oder in ihren Teilen (40) mit Mitteln zur Befestigung eines Bedien- oder Steckelements, insbesondere eines Frontsteckergehäuses (18), versehen sind.

10. Frontsystem nach Anspruch 1 und 9, dadurch gekennzeichnet, daß die Frontleiste (17) mit mindestens einer Durchbrechung zur Aufnahme eines mit den Formstücken (20) an der Baugruppe (1) befestigten Frontsteckergehäuses (18) versehen ist.

11. Frontsystem nach Anspruch 1, gekennzeichnet durch Blindplatten (28) zur Überdeckung der Front von nicht mit Baugruppen (1) besetzten Teilen des Baugruppenträgers und mit Mitteln zur mechanischen und elektrisch leitenden Verbindung mit Endstücken (2) bzw. mit den auf Massepotential liegenden Teilen des Baugruppenträgers.

12. Frontsystem nach Anspruch 11, dadurch gekennzeichnet, daß die Blindplatte (28) auf ihrer Rückseite mit Laschen (29) zur Verbindung mit Endstücken (2) versehen ist.

13. Frontsystem nach Anspruch 11, dadurch gekennzeichnet, daß die Blindplatte (28) mit rechtekkiger Frontseite (53) von ihrer Rückseite her zu den Schmalseiten (55) verlaufende Abschrägungen (56) aufweist und daß an einem Ende ein rechtwinklig nach rückwärts gerichteter, in den Hohlraum (6) der Profilschiene (5) einführbarer Fortsatz (57) vorhanden ist und daß die Länge (1) der Blindplatte (28) um etwa die Tiefe der Nut (15) größer ist als der Abstand zwischen den einander zugekehrten Flächen der Außenschenkel der Profilschienen (5).

14. Frontsystem nach Anspruch 13, dadurch gekennzeichnet, daß die Blindplatte (28) ein Blechbiegeteil ist oder aus U-Profilmaterial hergestellt ist, mit rechtwinklig hochgezogenen Längsseiten (54) mit gegen die Schmalseiten (55) verlaufenden Abschrägungen (56) und an einer Schmalseite abgebogenem Fortsatz (57).

15. Frontsystem nach Anspruch 11, dadurch gekennzeichnet, daß die Blindplatte (28) von einem metallischen Strangpreßprofil quer zur Preßrichtung trennbar ist.

16. Frontsystem nach Anspruch 15, dadurch gekennzeichnet, daß das Strangpreßprofil in dem Mehrfachen von Höheneinheiten (HE) des Frontsystems entsprechenden Abständen seiner Breite mit in Längsrichtung verlaufenden Rippen (58) mit rampenartig gegen die Plattenebene geneigten Abschrägungen (56) versehen ist.

17. Frontsystem nach Anspruch 16, dadurch gekennzeichnet, daß von den Rippen (58) senkrecht zur Plattenebene verlaufende Vorsprünge (59) ausgehen.

## Claims

1. Front system for plug-in modules which can be plugged into mounting racks, and frame-like mounting racks for receiving the same, having, mounted at the corners of the front edges of the plug-in modules, angle levers the one lever arm of which is supported on the respective front frame and the other lever arm of which is constructed as a handle, characterized by:

a) two parallel mounting channels (5) extending perpendicularly to the plane of the plug-in unit, having a U-shape open to the front, which mounting channels are parts of the front frame of the mounting rack, which mounting channels are provided over their whole length with contact means (7, 43) arranged in the cavity of the section and connected to earth;

b) end pieces (2) at the corners of the front edge, fastened on to each plug-in module (1) and connected to an earth conductor of the plug-in module, which end pieces are provided with a part (9, 46) which can be connected with the contact means (7, 43) in a conducting manner, and on which end pieces the angle levers (4) are mounted with their rotary axes being perpendicular to the plane of the plug-in unit;

c) a front border (17), consisting of electroconductive section material, having means for connection to the front edge of the plug-in module (1) and/or to the end pieces (2).

2. Front system according to claim 1, characterized by:
– a slot (15), in the inner side of that limb of the mounting channel (5) which lies on the outside, extending parallel to the leading edge of the limb,
– a lug (14) attached to the end of the supported lever arm (10) of the angle lever (4), which lug fits into the slot (15).

3. Front system according to claim 1, characterized by:
– a latching device (12, 13) attached to the lever arm (11) of the angle lever (4), the lever arm (11) being constructed as a handle, and the latching device fitting into an opening (16) in the front border (17) and/or into an opening (16') in the end piece (2).

4. Front system according to claim 3, characterized in that the latching device consists of a plate spring (13) which extends from the free end of the lever arm (11) in the direction of the rotary axis of the angle lever (4) and which is provided with a latching lug (12) at its end.

5. Front system according to claim 1 and 4, characterized in that the front border (17), and/or a projection (24) of the end piece (2) extending beneath the angle lever axis, is provided with a respective opening (16, 16'), the latching lug (12) gripping behind one of the edges of the openings, the edges being parallel to the rotary axis of the angle lever (4).

6. Front system according to claim 1, characterized in that the contact means in the cavity (6) of the mounting channel (5) is a plate spring (7) with spring tongues (8) constructed like a comb, and in that each end piece (2) is provided with a tongue-shaped contact surface (9) which extends parallel to the direction of the plug-in unit and which is in contact with the plate spring (7) when the plug-in module (1) is plugged in.

7. Front system according to claim 1, characterized in that the contact means is at least one contact bar (43) provided with a series of threaded holes (44), which contact bars are inserted into two slots (45, 45') facing each other in the inner sides of the limb of the U-shape of the mounting channel (5) and in that the end pieces (2) can be fastened on to the contact bars (43) by means of screwed connections (50).

8. Front system according to claim 1, characterized in that, as a means to connect the front border (17) with the unit (1), fittings (20) are provided which, on the one hand, are to be fastened to the front edge of the unit (1) by means of a square-shaped part (38) and which, on the other hand, are constructed in such a way that they are held in a hollow section of the front border (17), the hollow section opening towards the unit, so that they can be displaced longitudinally and so that they interlock.

9. Front system according to claim 1 and 8, characterized in that on or in their parts (40), electroconductive fittings (20) are provided with the means for fastening an operator element or plug-in element, more particularly a front plug housing (18).

10. Front system according to claim 1 and 9, characterized in that the front border (17) is provided with at least one opening for receiving a front plug housing (18) which is fastened on to the unit (1) by means of the fittings (20).

11. Front system according to claim 1, characterized by blanking plates (28) for covering up the front from parts of the mounting rack which are not occupied by units (1), and having means for the mechanical and electroconductive connection with end pieces (2) or with the parts of the mounting rack which lie at earth potential.

12. Front system according to claim 11, characterized in that on its rear side, the blanking plate (28) is provided with shackles (29) for the connection with end pieces (2).

13. Forint system according to claim 11, characterized in that the blanking plate (28) with a rectangular front side (53) has bevels (56) extending from its rear side to the narrow sides (55), in that at one end there is a projection (57) which is arranged at right angles towards the rear and which can be inserted into the cavity (6) of the mounting channel (5), and in that the length (1) of the blanking plate (28) is greater than the distance between the surfaces, directed towards one another, of the outer limb of the mounting channels (5) by about the depth of the slot (15).

14. Front system according to claim 13, characterized in that the blanking plate (28) is a part made of bent plate or is manufactured from U-shaped material, having longitudinal sides (54) raised at right angles, with bevels (56) extending towards the narrow sides (55) and with a projection (57) which is bent at a narrow side.

15. Front system according to claim 11, characterized in that the blanking plate (28) can be separated from a metallic press-drawn section at right angles to the press direction.

16. Front system according to claim 15, characterized in that the press-drawn section is provided, across its width, at separations corresponding to a plurality of height units (HE) of the front system, with longitudinally extending ribs (58), having bevels (56) tending in a ramp-like fashion towards the plate plane.

17. Front system according to claim 16, characterized in that projections (59) emanate from the ribs (58) extending perpendicularly to the plate plane.

**Revendications**

1. Système frontal pour des modules enfichables, pouvant être insérés dans des porte-modules, et pour des porte-modules en forme de cadres pour le stockage des modules, comportant des leviers coudés, qui sont montés aux angles des arêtes frontales des modules enfichables et dont un bras de levier prend appui respectivement sur le cadre frontal et dont l'autre bras de levier est réalisé sous forme d'une poignée, caractérisé par

a) deux rails profilés parallèles (5) perpendiculaires au plan d'insertion et possédant un profil en U s'ouvrant vers l'avant et constituant des parties du cadre frontal du porte-modules, qui sont équipées, sur toute leur longueur, de moyens de contact (7, 43) disposés dans la cavité du profilé et reliés à la masse;

b) des éléments d'extrémité (2), qui sont fixés aux angles de l'arête frontale de chaque module enfichable (1), sont reliés au conducteur de masse du module enfichable et sont pourvus d'une partie (9, 46) pouvant être reliée de façon conductrice aux moyens de contact (7, 43) et sur lesquels les leviers coudés (4) sont supportés par leurs axes de rotation perpendiculairement au plan d'insertion;

c) une barrette avant (17) réalisée en un matériau profilé électriquement conducteur et comportant des moyens destinés à la relier à l'arête frontale du module enfichable (1) et/ou aux éléments d'extrémité (2).

2. Système frontal suivant la revendication 1, caractérisé par

– une rainure (15) qui est ménagée dans la face intérieure de la branche extérieure du rail profilé (5) et s'étend parallèlement à l'arête avant de ce rail,

– un bec (14) situé sur l'extrémité du bras de levier de support (10) du levier coudé (4) et s'engageant dans la rainure (15).

3. Système frontal suivant la revendication 1, caractérisé par

– un dispositif d'encliquetage (12, 13) qui est disposé sur le bras de levier (11), réalisé sous la forme d'une poignée, du levier coudé (4) et s'engageant dans une ouverture (16) ménagée dans la barrette avant (17) et/ou dans une ouverture (16') ménagée dans l'élément d'extrémité (2).

4. Système frontal suivant la revendication 3, caractérisé par le fait que le dispositif d'encliquetage est constitué par un ressort en forme de lame (13) qui s'étend depuis l'extrémité libre du bras de levier (11) en direction de l'axe de rotation du levier coudé (4) et comporte, au niveau de son extrémité, un bec d'encliquetage (12).

5. Système frontal suivant les revendications 1 et 4, caractérisé par le fait que la barrette avant (17) et/ou un prolongement (24), qui s'étend au-dessous de l'axe du levier coudé, de l'élément d'extrémité (2) comporte respectivement une ouverture (16, 16'), le bec d'encliquetage (12) s'engageant derrière l'une des arêtes de cette ouverture, qui est parallèle à l'axe de rotation du levier coudé (4).

6. Système frontal suivant la revendication 1, caractérisé par le fait que le moyen de contact situé dans la cavité (6) du rail profilé (5) est un ressort en forme de lame (7) comportant des languettes élastiques (8) en forme de peigne, et que chaque élément (2) comporte une surface de contact en forme de languette (9), qui s'étend parallèlement à la direction d'introduction et est en contact avec le ressort en forme de lame (7) lorsque le module enfichable (1) est à l'état inséré.

7. Système frontal suivant la revendication 1, caractérisé par le fait que le moyen de contact est constitué par au moins un rail de contact (43) pourvu d'une série de trous taraudés (44), le ou les rails de contact étant insérés dans deux rainures (45, 45') qui se font face et sont ménagées dans les côtés intérieurs des branches du profilé en U du rail profilé (5), et que les éléments d'extrémité (2) peuvent être fixés à l'aide de liaisons vissées (5) aux rails de contact (43).

8. Système frontal suivant la revendication 1, caractérisé par le fait qu'il est prévu, comme moyens pour relier la barrette avant (17) au module (1), des pièces de forme (20) qui d'une part doivent être fixées par une pièce parallélépipédique (38) sur l'arête avant du module (1) et d'autre part sont agencées de telle sorte qu'elles sont maintenues de manière à être déplaçables longitudinalement et selon une liaison par formes complémentaires dans un profilé creux, qui s'ouvre en direction du module, de la barrette avant (17).

9. Système frontal suivant les revendications 1 et 8, caractérisé par le fait que des pièces de forme (20) électriquement conductrices comportent, sur ou dans leurs parties (40), des moyens de fixation d'un élément de service ou d'un élément d'enfichage, notamment d'un logement (18) pour connecteur frontal.

10. Système frontal suivant les revendications 1 à 9, caractérisé par le fait que la barrette avant (17) comporte au moins un passage servant à loger un boîtier (18) de connecteur frontal, fixé par les pièces de forme (20) au module (1).

11. Système frontal suivant la revendication 1, caractérisé par des plaques de masquage (28) servant à recouvrir l'avant de parties, non occupées par les modules (1), du porte-modules et comportant des moyens pour établir une liaison mécanique et électriquement conductrice avec des éléments d'extrémité (2) ou avec les parties, raccordées au potentiel de masse, du porte-modules.

12. Système frontal suivant la revendication 11, caractérisé par le fait que la plaque de masquage (28) comporte, sur sa face arrière, des pattes (29) pour sa liaison avec les éléments d'extrémité (2).

13. Système frontal suivant la revendication 11, caractérisé par le fait que la plaque de masquage (28) possédant une face avant (53) rectangulaire, comporte des biseaux (56) s'étendant depuis sa face arrière en direction des petits côtés (55), et qu'un prolongement (57) dirigé perpendiculairement vers l'arrière et pouvant pénétrer dans la cavité (6) du rail profilé (5) est prévu sur une extrémité de la plaque et que la longueur (1) de la plaque de masquage (28) est supérieure, d'une valeur correspondant approximativement à la profondeur de la rainure (15), à la distance entre les surfaces, tournées l'une vers l'autre, des branches extérieures des rails profilés (5).

14. Système frontal suivant la revendication 13, caractérisé par le fait que la plaque de masquage (28) est une pièce pliée en tôle ou bien est fabriquée à partir d'un matériau profilé en U, et comporte des côtés longitudinaux (54) relevés à angle droit et portant des biseaux (56) s'étendant vers les petits côtés (55), et un prolongement (57) replié contre un petit côté.

15. Système frontal suivant la revendication 11, caractérisé par le fait que la plaque de masquage (28) peut être découpée à partir d'un profilé métallique extrudé transversalement par rapport à la direction de refoulement.

16. Système frontal suivant la revendication 15, caractérisé par le fait que le profilé extrudé comporte, à des intervalles correspondant à un multiple d'unités de hauteur (HE) du système frontal, sur son étendue en largeur, des nervures (58) s'étendant dans la direction longitudinale et comportant des biseaux (56) inclinés sous la forme de rampes par rapport au plan de la plaque.

17. Système frontal suivant la revendication 16, caractérisé par le fait que des parties saillantes (59) perpendiculaires au plan de la plaque s'étendent à partir des nervures (58).

FIG 1

FIG 8

FIG 9

FIG 2

FIG 3

FIG 4

FIG 5

FIG 6

FIG 7

FIG 10

FIG 11

FIG 12

FIG 13

FIG 14

FIG 15

FIG 16